## Europäisches Patentamt
## European Patent Office
## Office européen des brevets

(19)

(11) Publication number: **0 378 179 B1**

(12) # EUROPEAN PATENT SPECIFICATION

(45) Date of publication of patent specification: **12.10.94**　(51) Int. Cl.5: **G01V 3/10, H03K 17/95**

(21) Application number: **90100387.1**

(22) Date of filing: **09.01.90**

(54) **Microwave proximity switch.**

(30) Priority: **10.01.89 JP 1986/89**
　　　　　　**10.01.89 JP 1987/89**

(43) Date of publication of application:
　**18.07.90 Bulletin 90/29**

(45) Publication of the grant of the patent:
　**12.10.94 Bulletin 94/41**

(84) Designated Contracting States:
　**AT BE CH DE DK ES FR GB GR IT LI NL SE**

(56) References cited:
　**US-A- 4 215 341**

　**PATENT ABSTRACTS OF JAPAN, vol. 12, no. 138 (P-695), 27 April 1988 & JP-A-62 259048**

　**PATENT ABSTRACTS OF JAPAN, vol. 6, no. 55 (E-101), 10 April 1982 & JP-A-56 168405**

　**PATENT ABSTRACTS OF JAPAN, vol. 6, no. 47 (E-99), 26 March 1982 & JP-A-56 162504**

(73) Proprietor: **OMRON CORPORATION**
**10, Tsuchido-cho**
**Hanazono**
**Ukyo-ku**
**Kyoto 616 (JP)**

(72) Inventor: **Takinami, Takaharu, c/o OMRON CORPORATION**
**Intell. Prop. Center, 20, Igadera Shimokaiinji**
**Nagaokakyo-shi, Kyoto 617 (JP)**
Inventor: **Tsujino, Koichi, c/o OMRON COR-PORATION**
**Intell. Prop. Center, 20, Igadera Shimokaiinji**
**Nagaokakyo-shi, Kyoto 617 (JP)**

(74) Representative: **WILHELMS, KILIAN & PART-NER Patentanwälte**
**Eduard-Schmid-Strasse 2**
**D-81541 München (DE)**

EP 0 378 179 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a microwave proximity switch for sensing whether or not an object which causes a loss in a leakage magnetic field from a circuit system having a microwave band oscillator circuit is present in the proximity thereof.

Conventionally, there have been adopted various kinds of proximity switches, which however are attended with disdavanitges as follows.

In a high frequency proximity switch, a sensing or sense distance in which the switch is effective is small, namely, is at most half the diameter of a sense coil used in the switch (e.g. for a coil having a diameter 12 millimeters, mm, the sense distance is two millimeters). In consequence, when the switch includes a sense coil having a small diameter, there may occur a case where an object to be sensed collides with a sensor head.

In an ultrasonic proximity switch, a reverberation of a mechanical vibration of an ultrasonic vibrator thereof makes it difficult to sense an object existing within a range at most 5 centimeters, cm (to ten centimeters) from the proximity of the sensor. In production sites such as factories and firms, ultrasonic waves generated, for example, by a collision of a work may also cause a wrong operation.

In a photoelectric switch, owing to properties of light, it is difficult to sense reflection light from objects such as a transparent object like glass and an object having a matted black surface. Namely, such an object cannot be easily sensed. Furthermore, depending on a degree of dirtiness of a lens of the sensor, dirts or oils thereon, etc., characteristics of the sensor such as a sense distance are disadvantageously varied.

In the microwave proximity sensor of the prior art, since the sense operation is carried out based on a Doppler effect (of a differential output type), there arises a difficulty when a stationary object is to be sensed. Moreover, for sensors of which the intensity of electric field is at least 3.5 f ($\mu$ V/m), where the frequency is in the unit of gigahelz, GHz and the value is obtained at a distance of three meters from the sensors, an approval is necessary for each sensor in conformity with the Radio Law.

From US-A-4 215 341 an intrusion or movement detector is known which acts as a transmitter and detects changes in a signal amplitude caused by changes in antenna loading.

Patent abstracts of Japan of JP-A-56 168 405 discloses a microwave oscillator using a microstrip line.

It is therefore an object the present invention to provide a microwave proximity switch which can continuously sense an object at a relatively short distance therefrom in a range beginning from a distance 0 mm, which is resistive against dirts and dust, and which can also sense a stationary object.

A microwave proximity switch in accordance with the invention is defined in claim 1.

The change in the oscillation state of the microwave osillator circuit includes an alteration in an oscillation frequency and a variation in an oscillation output from the microwave oscillator circuit.

The micro strip line may be any transmission line applicable to a microwave oscillator circuit which causes a leakage magnetic field to be generated, for example, a slot line and a tranmission line in a spiral shape may be adopted.

In the microwave proximity switch, when a loss of the leakage magnetic field from the micro strip line is caused due to an object to be sensed approaching the switch (e.g. an eddy current loss or a skin effect loss in a case of a metal), there appears a change in the impedance of the micro strip line, which leads to a variation in the oscillation frequency or output of the oscillator circuit. Namely, an approach of an object can be detected by sensing the change in the oscillation frequency and/or output.

Since the leakage magnetic field from the micro strip line or the dielectric resonator exponentially decreases or attenuates as the distance between the switch and the object is increased, when the distance is about several times the microwave frequency (i.e. about several tens of centimeters), the intensity of leakage magnetic field is sufficiently attenuated to a very low radio level. As a result, with respect to the utilization of the sensor, the switch is beyond the restricted range of the Radio Law. In consequence, the switch can be more conveniently handled by the user.

Furthermore, the loss of the leakage magnetic field from the micro strip line or the dielectric resonator also takes place when the object is relatively in a stationray state, which consequently enables the switch to sense a stationary object. Namely, there is attained a wider application range for the sensor.

It is natural that the switch is not associated with a dead zone as this is the case in an ultrasonic switch and hence is applicable to a sense operation in a range beginning from the distance of 0 mm. Moreover, thanks to the property of the microwave, the switch is resistive against dusts and dirts. As compared with the high frequency proximity switch, the sense distance can be elongated by use of the switch in accordance with the present invention.

These and other objects and advantages of the present invention will become apparent by reference to the following description and accompanying drawings wherein:

FIG. 1 is a schematic block diagram showing an electric constitution of a microwave proximity switch;

FIG. 2 is a diagram schematically showing a Colpitts oscillator circuit as an example of the microwave band oscillator circuit in a first embodiment in accordance with the present invention;

FIG. 3 is a schematic diagram showing a micro strip line terminated with a capacitor adopted as an inductor of the oscillator circuit above;

FIG. 4 is a graph showing a change in an oscillation frequency of the oscillator circuit with respect to the distance to an object to be sensed;

FIG. 5 is a perspective view illustratively showing a configuration of a micro strip line and a leakage magnetic field;

FIG. 6 is a cross-sectional view of the micro strip line;

FIGS. 7 and 8 are schematic diagrams showing another example of the microwave transmission line in which FIG. 7 is a perspective view and FIG. 8 is a plan view only including the strip line;

FIG. 9 is a schematic circuit diagram showing an example of an oscillation circuit;

FIG. 10 is a circuit diagram schematically showing an example of a microwave band oscillator circuit in a second embodiment in accordance with the present invention;

FIG. 11 is a perspective view showing a state in which a micro strip line is linked with a dielectric resonator; and

FIG. 12 is a diagram schematically showing an equivalent circuit of the configuration of FIG. 11.

Referring now to the drawings, description will be given of an embodiment of the microwave proximity switch according to the present invention.

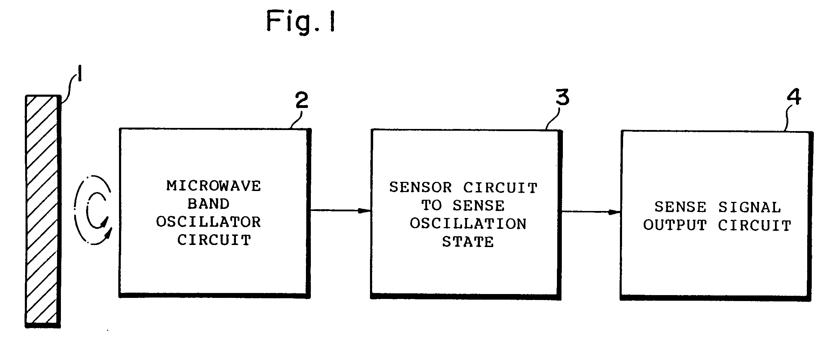

FIG. 1 is a block diagram showing the constitution of a microwave proximity switch.

The microwave proximity switch includes an oscillator circuit 2 to conduct an oscillation with a frequency (wavelength) in a microwave band, a sensor circuit 3 for sensing a change in the oscillation state (a change in the oscillation frequency or output) of the oscillator circuit 2 when an object 1 to be sensed approaches the vicinity of the oscillator circuit 2, and an output circuit 4 for converting a signal sensed by the sensor cirucit 3 into an output signal in a predetermined format.

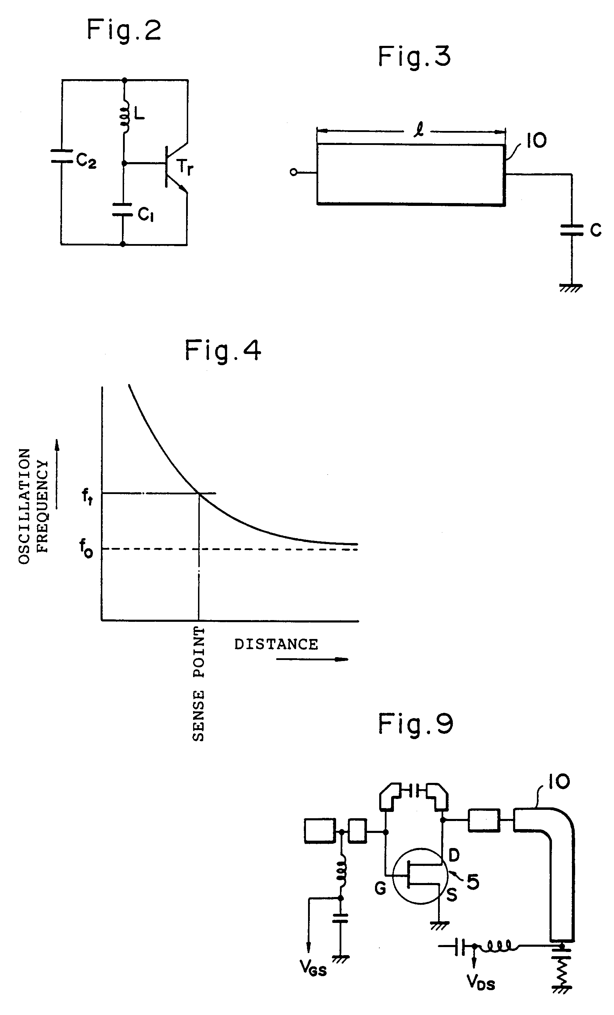

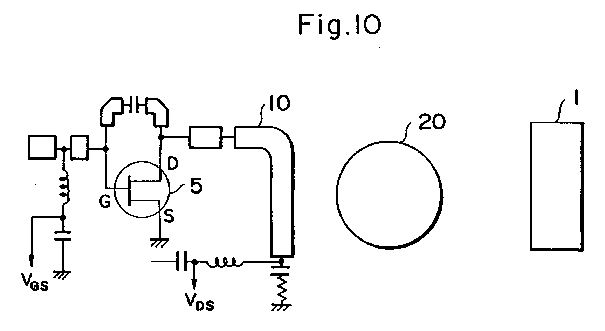

FIG. 2 shows a Colpitts oscillator circuit as an example of the microwave band oscillator circuit 2. The Colpitts oscillator circuit is a well-known oscillator circuit comprising as a feedback circuit a resonance circuit including an inductor L and capacitors $C_1$ and $C_2$. There has been employed as the inductor of the Colpitts oscillator circuit, as shown in FIG. 3, a circuit structure in which a micro strip line 10 is terminated with a capacitor C. FIG. 9 shows an example of an oscillator circuit including the constitution above and a field-effect transistor, FET, 5.

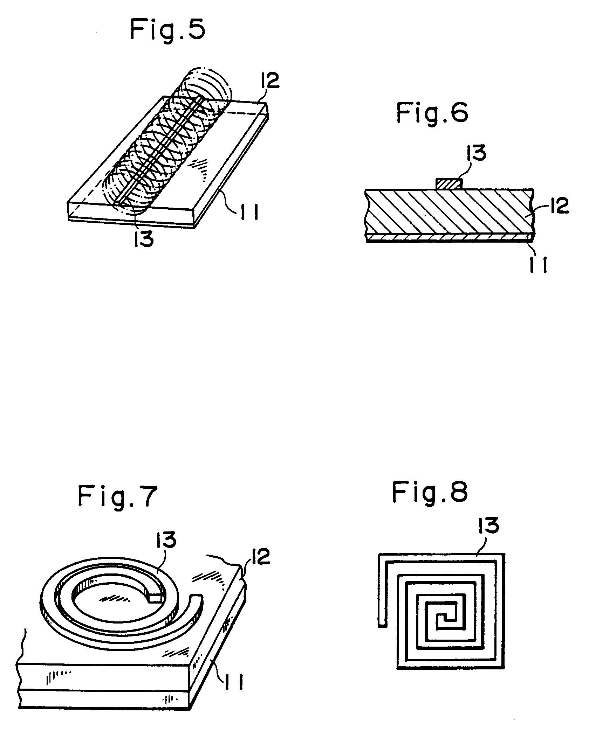

FIG. 5 shows an example of the configuration of the micro strip line, whereas FIG. 6 is a cross-sectional view thereof. On a surface a dielectric substrate 12, there is formed a thin metal film 11. Disposed on another surface thereof is a strip line 13. In this constitution, a microwave propagates through the dielectric substrate 12 to generate a leakage magnetic field as indicated with dot-and-dash lines in FIG. 5.

In the micro strip line of this type, when the length thereof is at most $\lambda_g/4$ ( $\lambda_g$ is a wavelength of the microwave in the dielectric material), the reactance of the line becomes to be inductive and can be hence used as an inductor. For example, under conditions of $\lambda_g/4 = 10$ mm and permittivity of dielectric substance $\epsilon_r = 10$, since $\lambda_g = \lambda_0/\sqrt{\epsilon_r}$, it is possible to propagate a microwave with a frequency $f_o = 3$ GHz. In consequence, the size of the sensor head can be considerably minimized.

In a case where the object to be sensed 1 is found in the neighborhood of the leakage magnetic field produced from the micro strip line 10, a loss takes place in the magnetic field and hence the state of oscillation is altered in the oscillator circuit 2. For example, the oscillation frequency of the oscillator circuit 2 varies, as shown in the graph of FIG. 4, in association with the distance between the micro strip line 10 and the object 1. Consequently, in the sensor circuit 3, by achieving a frequency discrimination on the sensed frequencies depending on an appropriate threshold frequency $f_t$, there can be attained a sense signal designating the appearance of the object 1.

For the micro strip line 10, as can bee seen from FIGS. 7 and 8, it is possible to use a spiral line formed in a circular or rectangular shape.

FIG. 10 shows another example of the constitution of the microwave band oscillator circuit 2. This configuration includes a FET 5 and a resonance circuit, which comprises a micro strip line 10 as an inductor thereof. The circuit associated with the FET 5 is inductively linked via the micro strip line 10 with a micro dielectric resonator 20. The micro strip line 10 is identical to that described above.

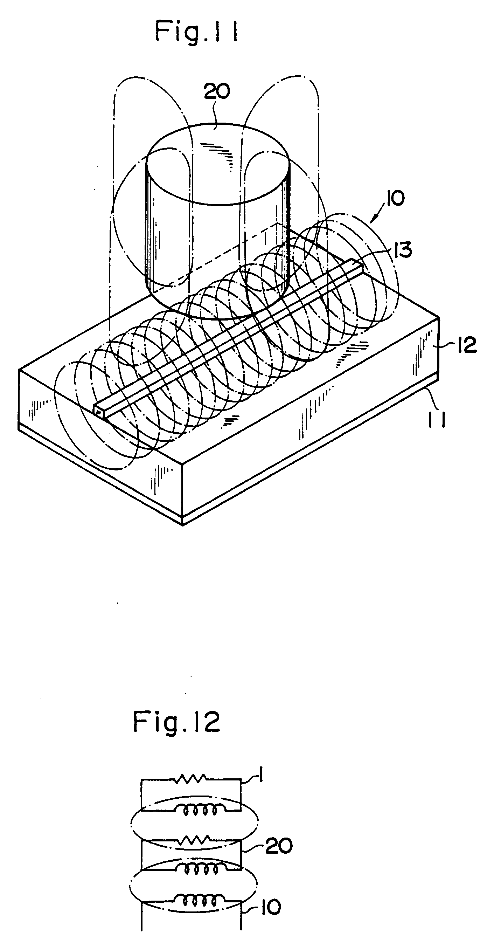

FIG. 11 shows a state of coupling established between the micro strip line 10 and a micro dielectric resonator 20, whereas FIG. 12 shows an equivalent circuit of the configuration of FIG. 11. As described above, the microwave propagates through the dielectric substrate 12 to generate a leakage magnetic field as indicated with dot-and-dash lines. Namely, the leakage magnetic field from the micro strip line 10 is coupled with the dielectric resonator 20 such that a leakage magnetic field is generated from the dielectric resonator 20 in association with a resonance in the transverse electric resonant mode, TE mode. When an object to be sensed 1 exists in the proximity of the leakage magnetic field generated from the dielectric resonator 20, there occurs a loss in the magnetic field, which leads to a variation in the state of oscillation of the oscillator circuit 2. For example, the oscillation frequency of the oscillator circuit 2 changes, as shown in the graph of FIG. 4, depending on the distance between the dielectric resonator 20 and the object 1. In consequence, in the sensor circuit 3, by conducting a frequency discrimination on the obtained frequencies depending on an appropriate threshold frequency $f_t$, there can be obtained a sense signal denoting the existence of the object 1.

For the micro strip line 10, as described above, it is possible to use a spiral line formed in a circular or rectangular shape. Furthermore, the dielectric resonator of a cylindrical shape and the micro strip line may be configured in an arbitrary arrangement if there can be developed an induction coupling therebetween in the transverse electric resonant mode.

In the embodiment above, although the object 1 is detected depending on a change in the oscillation frequency of the oscillator circuit 2, it is also possible for the object detection in a simplified construction that the oscillator circuit is designed with a negative conductance set to be as small as possible so as to sense an interruption of the oscillation. In more detail, when an object to be sensed enters a predetermined range of the sensor, the oscillator circuit interrupts its oscillation. This considereably alters the current consumption in the oscillator circuit. Namely, by sensing the change in the current, it is possible to sense an event that the object approaches the sensor.

Furthermore, the switch may be constituted such that a change in an impedance of the micro strip line terminated with a capacitor is sensed with a bridge circuit.

In the description above, although the Colpitts circuit is employed as an example of the oscillator circuit, there may be used a Hartley circuit including two inductors, a circuit utilizing three inductors, Clapp circuit and its variations, and any LC oscillator circuits suitable for the microwave band oscillation. In short, the switch can be implemented when the length of the inductor is $\lambda_g/4$ and the micro strip line is terminated with a capacitor of an appropriate capacitance.

While the particular embodiments of the invention have been shown and described, it will be obvious to those skilled in the art that various changes and modifications may be made without departing from the present invention as claimed.

**Claims**

1. A microwave proximity switch, characterized by

   a microwave oscillation circuit (2) comprising an inductive element (L) and a capacitive element ($C_1$, $C_2$) tuned to resonate at a microwave frequency, said inductive element comprising a microstrip line (10) terminated with a capacitor (C) and generating a leakage magnetic field;

   means (3) for sensing a change in the microwave oscillation frequency of the microwave oscillation circuit when an object (1) approaches the leakage magnetic field of the microstrip line; and

   output means (4) for outputting a signal indicative of said change in frequency.

2. A microwave proximity switch as claimed in claim 1, wherein the change in oscillation frequency includes an interruption of oscillation of the microwave oscillation circuit.

3. A microwave proximity switch as claimed in claim 1, further comprising a dielectric resonator (20) magnetically coupled with said microstrip line (10).

4. A microwave proximity switch as claimed in claim 3, wherein said dielectric resonator (20) is mounted adjacent said microstrip line on a dielectric substrate (12).

5. A microwave proximity switch as claimed in claim 4, wherein the dielectric resonator (20) generates a leakage magnetic field due to transverse mode resonance caused by the magnetic coupling with the microstrip line (10).

6. A microwave proximity switch as claimed in claim 1, wherein the microstrip line (10) has a length less than one quarter of the wavelength of the microwave oscillation frequency of the microwave oscillation circuit when no object (1) is present.

7. A microwave proximity switch as claimed in claim 1, wherein the microstrip line (10) comprises a strip line (13) and a conductive plate (11) disposed on one side of the strip line, the conductive plate being grounded.

**Patentansprüche**

1. Mikrowellen-Nährungsschalter, gekennzeichnet durch

eine Mikrowellen-Schwingungsschaltung (2) mit einem induktiven Element (L) und einem kapazitiven Element ($C_1$, $C_2$), die so abgestimmt ist, daß sie bei einer Mikrowellenfrequenz in Resonanz tritt, wobei das induktive Element einen mit einem Kondensator (C) abgeschlossenen und ein Streumagnetfeld erzeugenden Mikrostreifenleiter (10) aufweist;

Mittel (3) zum Abfühlen einer Änderung der Mikrowellen-Schwingungsfrequenz der Mikrowellen-Schwingungsschaltung, wenn sich ein Gegenstand (1) dem Streumagnetfeld des Mikrostreifenleiters nähert; und

Ausgabemittel (4) zum Ausgeben eines diese Frequenzänderung angebenden Signals.

2. Mikrowellen-Nährungsschalter nach Anspruch 1, wobei die Änderung der Schwingungsfrequenz eine Unterbrechung der Schwingung der Mikrowellen-Schwingungsschaltung umfaßt.

3. Mikrowellen-Nährungsschalter nach Anspruch 1, welcher ferner einen mit dem Mikrostreifenleiter (10) gekoppelten dielektrischen Resonator (20) aufweist.

4. Mikrowellen-Nährungsschalter nach Anspruch 3, wobei der dielektrische Resonator (20) benachbart zum Mikrostreifenleiter auf einem dielektrischen Substrat (12) angebracht ist.

5. Mikrowellen-Nährungsschalter nach Anspruch 4, wobei der dielektrische Resonator (20) ein Streumagnetfeld infolge Transversalmodus-Resonanz, bewirkt durch die magnetische Kopplung mit dem Mikrostreifenleiter (10), erzeugt.

6. Mikrowellen-Nährungsschalter nach Anspruch 1, wobei der Mikrostreifenleiter (10) eine Länge hat, die weniger als ein Viertel der Wellenlänge der Mikrowellen-Schwingungsfrequenz der Mikrowellen-Schwingungsschaltung bei nicht vorhandendem Gegenstand (1) ist.

7. Mikrowellen-Nährungsschalter nach Anspruch 1, wobei der Mikrostreifenleiter (10) eine Streifenleitung (13) und eine auf der einen Seite der Streifenleitung angeordnete leitfähige Platte (11) aufweist, wobei die leitfähige Platte geerdet ist.

**Revendications**

1. Un commutateur de proximité à micro-ondes caractérisé par :

un circuit d'oscillation de micro-ondes (2) comprenant un élément inductif (L) et un élément capacitif ($C_1$, $C_2$) accordés de manière à résonner à une fréquence de micro-ondes, ledit élément inductif comprenant une ligne de microbande (10) terminée par un condensateur (C) et engendrant un champ de fuite magnétique ;

un moyen capteur (3) d'une variation de la fréquence d'oscillation du circuit d'oscillation de micro-ondes quand un objet (1) s'approche de champ de fuite magnétique de la ligne de microbande ; et

un moyen de production (4) pour produire un signal indicatif de ladite variation de fréquence.

2. Un commutateur de proximité à micro-ondes selon la revendication 1, dans lequel la variation de fréquence d'oscillation inclut une interruption d'oscillation du circuit d'oscillation de micro-ondes.

3. Un commutateur de proximité à micro-ondes selon la revendication 1, comprenant en outre un résonateur diélectrique (20) couplé magnétiquement à ladite ligne de microbande (10).

4. Un commutateur de proximité à micro-ondes selon la revendication 3, dans lequel ledit résonateur électrique (20) est monté adjacent à ladite ligne de microbande sur un substrat diélectrique.

5. Un commutateur de proximité à micro-ondes selon la revendication 4, dans lequel le résonateur diélectrique (20) engendre a champ de fuite magnétique en raison d'une résonance en mode transversal provoquée par le couplage magnétique avec la ligne de microbande (10).

6. Un commutateur de proximité à micro-ondes selon la revendication 1, dans lequel la longueur de la ligne de microbande (10) est inférieure à un quart de la longueur d'onde de la fréquence d'oscillation du circuit d'oscillation de micro-ondes lorsqu'aucun objet (1) n'est présent.

7. Un commutateur de proximité à micro-ondes selon la revendication 1, dans lequel la ligne de microbande (10) comprend une ligne de bande (13) et une plaque conductrice (11) disposée sur un côté de la ligne de bande, la plaque conductrice étant à la masse.

## Fig. 1

EP 0 378 179 B1

Fig.2

Fig.3

Fig.4

OSCILLATION FREQUENCY

$f_t$

$f_0$

SENSE POINT

DISTANCE

Fig.9

$V_{GS}$

$V_{DS}$

8

Fig.5

12

11

13

Fig.6

13

12

11

Fig.7

13

12

11

Fig.8

13

Fig.10

Fig.11

Fig.12